# EUROPEAN PATENT SPECIFICATION

(11) **EP 1 521 634 B1**
(45) Date of publication and mention of the grant of the patent: **15.03.2006**
(21) Application number: 03740783.0
(22) Date of filing: 11.07.2003
(51) Int. Cl.: B01L 3/00

(54) **A METHOD OF PRODUCING A MICROFLUIDIC DEVICE**
VERFAHREN ZUR HERSTELLUNG EINER MICROFLUIDISCHEN VORRICHTUNG
PROCEDE DE PRODUCTION D'UN DISPOSITIF MICROFLUIDE

(30) Priority: 11.07.2002 GB 0216077
(43) Date of publication of application: 13.04.2005
(73) Proprietor: CRANFIELD UNIVERSITY, Milton Keynes, Bedfordshire MK45 4DT (GB)
(72) Inventor: BOSSI, Alessandra, I-21100 Varese (IT); TURNER, Anthony Peter Francis, Milton Keynes, Bedfordshire MK43 4DT (GB); PILETSKA, Olena Volodimirivna, Milton Keynes, Bedfordshire MK43 0EE (GB); PILETSKY, Sergey Anatoliyovich, Milton Keynes, Bedfordshire MK43 0EE (GB)
(74) Representative: Stuart, Ian Alexander
(86) International application number: PCT/GB2003/002994
(87) International publication number: WO 2004/007077

(56) References cited:
- WO-A-01/89788
- US-A1- 2002 053 399
- US-B1- 6 210 986

## Description

### TECHNICAL FIELD

The present invention relates generally to miniature instrumentation for chemical/biochemical analysis and chemical/biological sensing and, more specifically, to microfluidic devices, their production and use. It is particularly concerned with methods for creating microchannels, and to controlled manipulations of fluids and capillaries in microchannels. These microchannels and tools for their creating and manipulation can be used in a variety of applications, including capillary electrophoresis, liquid chromatography, and flow injection analysis.

### BACKGROUND ART

Microfluidic systems have become increasingly popular tools in electronics, biotechnology, and the pharmaceutical and related industries where they provide numerous advantages, including significantly smaller reagent requirements, high speed of analysis and the possibility for automation [U.S. Pat No 6,251,343 and U.S. Pat No 6,379,974]. Typical examples of such microfluidic devices are a miniature gas chromatograph fabricated on a silicon wafer [Doherty et al., LC-GC (1994), 12, 846-850], a planar microcapillary electrophoresis chip [Manz et al., Trends in Anal. Chem. (1990), 10, 144-149 and Manz et al., Adv. in Chromatog. (1993), 33, 1-66; U.S. Pat. No. 4,908,112 and U.S. Pat. No. 6,309,602], a chip for separation and processing of nucleic acids [U.S. Pat. No 6,344,326] and microchips for the performance of amplification reactions [U.S. Pat. No 5,498,392], chemical and biological analysis [U.S. Pat. No 4,908,112 and U.S. Pat. No 6,342,142] and binding assay [U.S. Pat. No 5,637,469]. In microfluidic devices the transport and direction of materials, e.g., fluids, analytes and reagents within the microfabricated device, has generally been carried out by: (a) creating a pressure gradient; (b) the use of electric fields; (c) the use of acoustic energy. In order to fabricate microfluidic devices, the biotechnology and pharmaceutical industries have recently applied some of the same technologies that have proved effective in the electronics industry, such as photolithography, wet chemical etching, laser ablation, injection molding etc. As microfluidic systems become more complex, the ability to design and use them, including user handling and system interfacing of such devices, becomes more and more difficult. It would therefore be advantageous to provide an improved method for the design of flexible and reconfigurable microfluidic devices capable of being readily adapted to specific separation or analytical tasks and free from the problems associated with the current methods of production of such small-scale devices.

### DISCLOSURE OF THE INVENTION

The present invention is generally directed to development of microfluidic systems and methods for their use. As used herein, the term "microscale" or "microfabricated" generally refers to features of a device which have at least one structural element with dimension (e.g., depth, width, length, diameter, etc) in the range of from about 0.01 µm to about 1000 µm.

The present invention enables one to provide microfluidic devices that combine the advantages of microfluidics with improved material handling characteristics and reduced costs for manufacturing.

The present invention provides microfluidic device that incorporates a body structure comprising a microchannel network disposed therein. The body structure may have a plurality of ports disposed in it, where each port is in fluid communication with one or more channels in the channel network. It may also contain either a plurality of electrodes connected to or integrated with one or more channels or another mechanism for directing thermal energy according to a set pattern. The microchannel network is created and maintained in the body structure by directing patterned energy flow, which results in partial melting of substrate material along the applied pattern.
The device may comprise a casing containing fusible substrate. The casing may be tubular or box-like, having top, bottom and side parts. The material of the casing is generally selected for robustness under the conditions to which the microfluidic device may be exposed, e.g. exposure to one or more of organic solvents, buffers with different pHs, high and low temperature, irradiation and application of electric fields. Accordingly, the material may include materials such as glass, quartz, silicon or polysilicon, silicon nitride, gallium arsenide, metals, their alloys, polymers, such as acrylates, methacrylates and oligourethanes, with non-exclusive examples of e.g. polymethylmethacrylate, polycarbonate, polyethylene, polypropylene, polyvinylchloride, polytetrafluoroethylene, polydimethylsiloxane, polysulfone, organometallic polymers, and composite materials consisting off, e.g. metals and silicon, polymers and glass.

The interior part of microfluidic devices comprises a substrate material which can be easily and reversibly changed from solid to liquid state by directing energy flow. Accordingly, in some preferred aspects, the substrate material may comprise water (ice), frozen organic solvents or gases, metals (e.g. gallium), organic or inorganic compounds, oligomers or polymers.

The microfluidic device prepared in accordance with the methods described herein, may contain a plurality of ports disposed in it, where each port is in fluid communication with one or more channels in the channel network and may also contain a plurality of electrodes connected/integrated with one or more channels. In some possible applications neither the ports for fluid communications nor the electrodes will be necessary (which means that the plurality in these cases will be "zero"). The ports and electrodes will have an external interface through the plurality of apertures/holes or connectors disposed through, e.g., top, bottom or side parts of the microfluidic device. In some applications the device will contain holes, which function as reservoirs for reagents or wastes. In some applications the microfluidic devices will include an optical detection window(s) or detector(s), e.g. pH sensor, grating couple or surface plasmon resonance device, mass spectrometer, integrated into or linked with top, bottom or side parts of the device. The ports for liquid communication may also be used as electrodes for current regulation.

If the core of the device is made of water then channel formation, use and re-forming is straightforward since water is a good conductor (especially if it contains an electrolyte such as HCl or salt). Equally for some chemical applications, melting of non-conductive material can be useful since the resulting capillary or capillaries in this case will constitute areas of facilitated diffusion. If necessary, channels can be refilled and re-formed again using other material stored in a reservoir in the body of the microfluidic device. Channels also can be refilled with the molten material of the same nature as core of the device.

In some designs the microfluidic device will contain a source of energy (e.g. light, heat, focused, particle (e.g. ion) beams and electron beams, electromagnetic or microwave radiation) which delivers reversible transformation of the substrate material in the interior part of the device from a solid to a liquid state.

In some embodiments, the microfluidic device also contains a heating/cooling device, heat exchanger or thermostat which maintains and controls the temperature in the microfluidic device, in particular in its interior part.

The source of energy, heating and / or cooling of the device may be integral parts of the microfluidic device, or external modules.

The casing may have integrated features such as electric circuits or liquid crystals.

The formation and maintenance of the integrated microchannel network in the interior part of the microfluidic device may be achieved by patterned direction of energy, e.g. heat or light into the interior part of microfluidic device. This application of energy results in partial melting of the substrate material of the interior part of the device according to a preset pattern in a way that ensures that the liquid channels are formed between the top and the bottom parts of the device. In different formats of the microfluidic device the energy will be applied to the interior part in different ways, including using light (e.g. a laser beam), heat (using e.g. IR laser), focused ionic, particle, X-ray and electron beams. In some embodiments the patterning will be achieved by focusing energy beams in pre-determined parts of the interior part through a transparent part of the casing or by using masks, which restrict the direction of energy to the predetermined areas of the interior part only. The advantages of the approach, described in this invention lies in the flexibility of the system. The pattern (and the patterned system of created microchannels) can be changed by re-focusing and re-directing the applied energy. The microchannel network will exist only when the energy is applied to corresponding areas. When the application of energy stops - the liquid in the channel will be frozen and channel will disappear. A plurality of integrated microchannels, including transverse channels, cross intersections, "T" intersections, etc., in the same microfluidic device can be created for a variety of specific applications. The microchannel network can also be modified in real time during the analytical or separation method to facilitate or promote individual stages of the experiment or analysis. The connection between the channels, reservoirs, ports for fluid communications and electrodes can be easily established or terminated by focusing energy at appropriate connection points.

In some embodiments, parts of the device (e.g. of the mask or top or bottom casing part) will contain liquid crystals capable of changing their properties according to the applied current. In this case the microchannel patterning will be achieved by modulating the transparency of the liquid crystals and correspondingly by regulating local heating produced by energy passed through the liquid crystal. In some embodiments the device will contain microcircuits capable of producing heat upon applying current. In this case the microchannels will be patterned according to structure of microcircuits and according to the pattern of applied current.

The pattern can be created, changed and controlled by a computer using appropriate software. The microfluidic device may be designed as a replaceable chip or stationary unit linked with samplers, liquid reservoirs etc.

The principle of creation and regulation of the channel network can also be used by the skilled artisan with nanoscale systems without deviation from the scope of the present invention.

Another aspect of the present invention involves the manipulation of material to be transported (liquidified part of substrate material, solution, analytes, sample etc.) inside of the microchannel network, formed according to the pattern of applied energy. A controlled current applied to multiple electrodes may be used to effect material transport. The connection between electrodes and channels will be established by directing energy to appropriate connection points. Alternatively or additionally the transport in microchannels may be regulated by applying a pressure gradient using external or integrated pumps, and/or using acoustic energy or temperature gradients. The transport of material may be regulated by freezing or melting part of the solution inside the microchannels to block or open a transport pathway.

The transport flow inside the microchannels may be modulated by modifying the properties of the microchannel surface. For example, the interior part of the microfluidic device may contain material which when exposed to solution will provide additional functions such as charge, hydrophobicity, affinity, recognition, sensing and catalytic elements. The introduction of affinity or recognition functions may be achieved by the introduction into the composition of the interior part and / or by the immobilisation onto the top, bottom or side part of the microfluidic device of a protein, biological receptor, nucleic acid, chromosome, cell, virus, microorganism, tissue sample, carbohydrate, oligosaccharide, polysaccharide, nucleoprotein, mucoprotein, lipoprotein, synthetic protein, glycoprotein, glucosaminoglycan, steroid, immunosuppressant, hormone, heparin, antibiotic, vitamin or drug. Upon melting, part of the introduced material will be exposed to the solution, thus providing an interacting point for selective binding, recognition or modulation of the solution properties. Alternatively or additionally, the introduction of affinity or recognition functions can be achieved by filling the microchannel or reservoir with solution, suspension or emulsion of a corresponding molecule, oligomer, polymer, tissue or cell and by freezing part of it in order to achieve an entrapment of these species into the walls of the microchannels or reservoirs.

The microfluidic devices may be used in a variety of applications, including, e.g., high throughput screening assays in drug discovery, immunoassays, diagnostics, genetic analysis, and the like. Another type of use is as a reagent mixing apparatus, lab-on-a-chip for performing chemical and / or biological experiments or as research platform for studying and optimising microfluidic processes.

### BRIEF DESCRIPTION OF THE DRAWINGS

FIG. 1 is a schematic view of a microfluidic device according to a first embodiment of the present invention.
FIG. 2 illustrates the formation of a microchannel network in the interior part of the microfluidic device shown in FIG. 2
FIG. 3 illustrates an alternative method for the formation of a microchannel network.
FIG. 4 is a graph illustrating a separation carried out by an embodiment of the invention.
FIG. 5 is a graph demonstrating that HRP can bind to proteins immobilised by freezing in ice.

### MODES FOR CARRYING OUT THE INVENTION

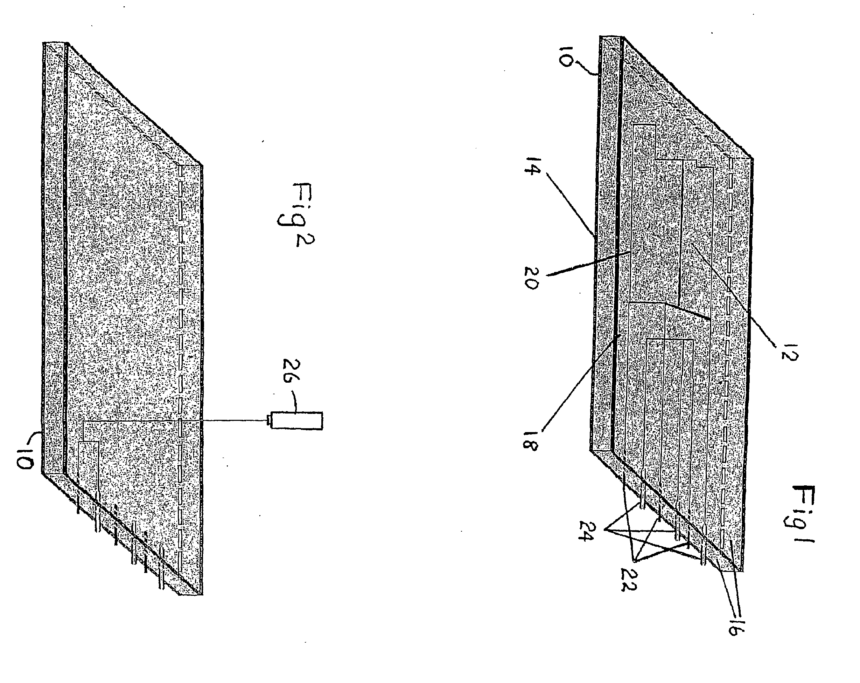

FIG. 1 shows a first embodiment of the invention. This is a microfluidic device that comprises a body structure with a microchannel network disposed therein. A casing 10 has the form of a thin rectangular box having large top and bottom parts 12,14 and side parts 16. The interior contains a fusible material 18 in which microchannels 20 are formed. As shown, the top and bottom parts of the device are formed of a solid material that is substantially planar in structure. The side parts of the device serves also for bonding together (and sealing) top and bottom parts and containing the interior part of the microfluidic device. The skilled artisan could design and use also essentially non-planar and stacked devices without deviating from the fundamental concept of the present invention.

The illustrated device has an end face through which a plurality of electrodes (22) and ports (24) for fluid communication extend. Energy is being applied, e.g. by scanning an IR laser, to melt a minor proportion of the fusible material 18 and maintain its molten state to create the illustrated pattern of microchannels (70) communicating with the electrodes (22) and ports (24).

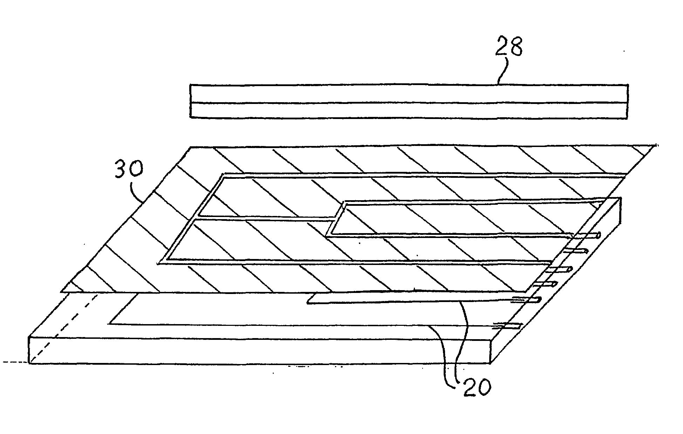

FIG. 2 shows an energy source 26, such as a laser or ion beam, which moves according to a predetermined pattern defined by e.g. PC software and melts the substrate material of the interior part of the microfluidic device thus creating microchannels. Continued scanning is required to maintain the pattern of microchannels.

FIG. 3 illustrates an alternative approach, in which a broad energy source 28 beams radiation at an entire major face of the device, and a mask 30 shields the device except in selected areas determined by the mask pattern 32 which corresponds to the pattern of microchannels 20.

Some practical experiments will now be described, illustrating embodiments of the invention and techniques that may be used in the invention.

### EXAMPLE 1

An ice crystal (2x2x2 cm) was illuminated with a 40 W CO₂ laser for 5 minutes. At the end of illumination it was found that a cylindrical hole of diameter 3 mm had been drilled through the crystal.

### EXAMPLE 2a

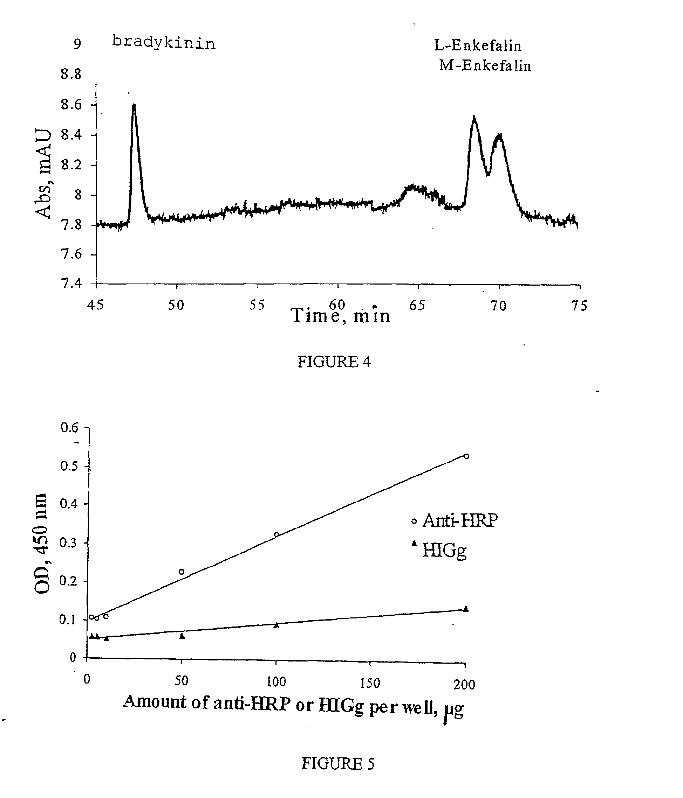

A 60 cm glass capillary (75 µm internal diameter) was filled with 10 mM HCl and frozen at -20 °C. The capillary was mounted in a Waters 4000 E capillary electrophoresis instrument supplied with a thermostat. The applied potential was 10000 V and the temperature was maintained at -20 °C. After 1 hour an internal part of the ice in capillary had been melted due to the applied potential, and the current passing through the system increased to 0.2 µA, after which it stabilised. A solution containing 1mg/ml of each of bradykinin, L-enkefalin and M-enkefalin was injected into the capillary by hydrostatic pressure. The electropherogram which shows the achieved separation on ice-filled capillary is presented in Figure 4.

### EXAMPLE 2b

A 60 cm glass capillary (75 µm internal diameter) was filled with 10 mM HCl and frozen at -20 °C. The capillary was mounted in Waters 4000 E capillary electrophoresis instrument supplied with thermostat. The applied potential was 10000 V and the temperature was maintained at - 5 °C. The current passing through the system stabilised at 1.5 µA which is an indication that ice has not been formed in the capillary. A mixture of bradykinin, L-enkefalin and M-enkefalin was injected into the capillary as in Example 2a. No separation was observed in this case due to absence of ice in capillary.

### EXAMPLE 3

Anti-HRP and HIGg (human immunoglobulin) were dissolved in water in concentrations 4 mg/ml, 2 mg/ml, 1 mg/ml, 0.2 mg/ml, 0.1 mg/ml, and 0.05 mg/ml. 50 µl portions of anti-HRP and HIGg solutions were transferred into microtitre plates in three replicates. The microtitre plates with samples have been frozen for 30 min at -18 °C. 50 µl of 10 µg/ml HRP was added to wells contained frozen anti-HRP and HIGg solutions with subsequent incubation for 5 min. Washing conditions: 3 times with 150 µl of water contained 0.05% Tween 20. All solutions were kept at 4 °C. The concentration of adsorbed HRP was measured with 100 µl of ABTS solution (6 mg of ABTS and 3 µl of 30% H₂O₂ per 10 ml of 100 mM Na-citrate buffer, pH 6.0). The optical absorbance was measured at 450 nm. The result shows preferential binding of antigen (HRP) to corresponding anti-HRP antibodies immobilised by freezing in ice. This is illustrated by FIG. 5. This is clearly applicable to embodiments of the invention. A device may include a microcapillary formed in ice containing a protein (or other macromolecule), and an analyte passed along the capillary may interact (e.g. bind) with that protein.

### EXAMPLE 4

An ice crystal (10x10x1 cm) was covered with a mask made of aluminium foil with a pattern, and subjected to illumination with visible light (100 Wt) for 10 minutes. A track with dimension 1x20 mm was formed in the ice. It was filled with dye (gallocyanine) for a contrast.

## Claims

1. A method of producing a microfluidic device comprising (a) providing a body comprising fusible material; and (b) selectively applying energy so that a portion of the fusible material melts, thereby creating one or more microchannels in the body.

2. A microfluidic method comprising (i) producing a microfluidic device by the method of claim 1; and (ii) passing an analyte material into a said microchannel.

3. A method according to claim 2 in which energy is also selectively applied during step (ii) to maintain and/or to alter the microchannel(s).

4. A method according to any preceding claim wherein said body comprises a casing of material that is not fusible is use, and fusible material within said casing.

5. A method according to any preceding claim wherein there are electrodes projecting into the body.

6. A method according to any preceding claim wherein said selective application of energy is effected by the application of a beam of radiation or particles and/or by the application of a voltage.

7. A method according to any preceding claim wherein the fusible material is ice, optionally containing a dissolved electrolyte.

8. A method according to any preceding claim wherein the body contains one or more cavities, optionally produced by said selective application of energy, communicating with one or more of said microchannels to function as reservoirs.

9. A method according to any preceding claim wherein the device is provided with one or more detection windows and/or detection devices.

10. A method according to any preceding claim wherein the device includes means for use in said selective application of energy.

## Revendications

1. Procédé pour produire un dispositif de microfluidique comprenant les étapes consistant à (a) fournir un corps comprenant un matériau fusible ; et (b) appliquer sélectivement une énergie de sorte qu'une partie du matériau fusible fonde, créant ainsi un ou plusieurs micro-canaux dans le corps.

2. Procédé de microfiuidique comprenant les étapes consistant à (i) produire un dispositif de microfluidique par le procédé selon la revendication 1 ; et (ii) faire passer un matériau d'analyte dans un dit micro-canal.

3. Procédé selon la revendication 2 dans lequel l'énergie est aussi appliquée sélectivement pendant l'étape (ii) pour maintenir et/ou modifier le ou les micro-canaux.

4. Procédé selon l'une quelconque des revendications précédentes dans lequel ledit corps comprend un boîtier de matériau qui n'est pas fusible pendant l'utilisation, et un matériau fusible dans ledit boîtier.

5. Procédé selon l'une quelconque des revendications précédentes dans lequel des électrodes se projettent dans le corps.

6. Procédé selon l'une quelconque des revendications précédentes dans lequel ladite application sélective d'énergie est réalisée par application d'un faisceau de rayonnement ou de particules et/ou par l'application d'une différence de potentiel.

7. Procédé selon l'une quelconque des revendications précédentes dans lequel le matériau fusible est de la glace, contenant facultativement un électrolyte dissous.

8. Procédé selon l'une quelconque des revendications précédentes dans lequel le corps contient une ou plusieurs cavités, facultativement produites par ladite application sélective d'énergie, communiquant avec un ou plusieurs desdits micro-canaux pour fonctionner comme réservoirs.

9. Procédé selon l'une quelconque des revendications précédentes dans lequel le dispositif est doté d'une ou plusieurs fenêtres de détection et/ou d'un ou plusieurs dispositifs de détection.

10. Procédé selon l'une quelconque des revendications précédentes dans lequel le dispositif inclut des moyens pour une utilisation dans ladite application sélective d'énergie.

## Patentansprüche

1. Verfahren zur Herstellung einer Mikrofluidikvorrichtung, umfassend (a) Bereitstellung eines Körpers, der schmelzbares Material umfasst; und (b) selektive Zufuhr von Energie, so dass ein Teil des schmelzbaren Materials schmilzt, wodurch ein oder mehrere Mikrokanäle im Körper ausgebildet werden.

2. Mikrofluidikverfahren, umfassend (i) die Herstellung einer Mikrofluidikvorrichtung durch ein Verfahren nach Anspruch 1; und (ii) das Einströmenlassen eines Analytmaterials in den Mikrokanal.

3. Verfahren nach Anspruch 2, worin auch in Schritt (ii) selektiv Energie zugeführt wird, um den Mikrokanal oder die Mikrokanäle zu erhalten und/oder zu verändern.

4. Verfahren nach einem der vorangegangenen Ansprüche, worin der Körper ein Gehäuse aus einem Material, das während bei Verwendung nicht schmelzbar ist, und im Gehäuse ein schmelzbares Material umfasst.

5. Verfahren nach einem der vorangegangenen Ansprüche, worin sich Elektroden in den Körper hinein erstrecken.

6. Verfahren nach einem der vorangegangenen Ansprüche, worin die selektive Zufuhr von Energie durch Anwendung eines Strahlenbündels oder Teilchenstrahls und/oder durch Anlegen einer Spannung erfolgt.

7. Verfahren nach einem der vorangegangenen Ansprüche, worin das schmelzbare Material Eis ist, das gegebenenfalls einen gelösten Elektrolyten enthält.

8. Verfahren nach einem der vorangegangenen Ansprüche, worin der Körper ein oder mehrere Hohlräume umfasst, die gegebenenfalls durch die selektive Zufuhr von Energie ausgebildet werden und die mit einem oder mehreren der Mikrokanäle kommunizieren, um als Speicher zu dienen.

9. Verfahren nach einem der vorangegangenen Ansprüche, worin die Vorrichtung mit einem oder mehreren Detektionsfenstern und/oder einer oder mehreren Detektionsvorrichtungen ausgestattet ist.

10. Verfahren nach einem der vorangegangenen Ansprüche, worin die Vorrichtung Mittel zur Verwendung bei der selektiven Zufuhr von Energie umfasst.
